# EUROPEAN PATENT APPLICATION

(11) **EP 0 646 961 A2**
(43) Date of publication of application: **05.04.1995**
(21) Application number: 94113880.2
(22) Date of filing: 05.09.1994
(51) Int. Cl.: H01L 23/495

(54) **A lead frame structure and a method for manufacturing a semiconductor package device using the lead frame structure**

(30) Priority: 04.10.1993 JP 247810/93
(71) Applicant: KABUSHIKI KAISHA TOSHIBA, Kawasaki-shi, Kanagawa-ken 210 (JP)
(72) Inventor: Ikenoue, Kazuhisa, c/o Int. Prop. Div., Minato-ku, Tokyo 105 (JP)
(74) Representative: Ritter und Edler von Fischern, Bernhard, Dipl.-Ing.

(57) **Abstract**

A lead frame structure structure (15) used to produce a semiconductor package device having a semiconductor chip (10) comprising a die pad (3) having a surface on which the semiconductor chip (10) can be mounted, the die pad being to be buried in the package (12) in a subsequent process, a frame (2), tongue segments (4) extending from the frame (2), each having a inner lead (4a) opposed to the die pad (3) with a gap therebetween and a outer lead (4b) connected to the frame, die pad supports (6) for connecting the die pad (3) with the frame (2), the die pad supports (6) being to be cut in a subsequent process and dummy die pad supports (18) extending from the frame (2) and having such a length as not to reach the die pad (3), the dummy die pad supports (18) being to be cut in the process of cutting the die pad supports (6).

## Description

The present invention relates to a lead frame structure used to produce a semiconductor package device.

A lead frame structure used to produce a semiconductor package device generally comprises a die pad on which the semiconductor chip is mounted and a metal frame having a number of tongue segments which is to become leads of the semiconductor package device. The die pad is connected to the frame by linear members called "die pad supports".

When a semiconductor chip is packaged using the lead frame structure to form a semiconductor package device, the semiconductor chip is first fixed (mounted) to the die pad. This step is generally called "die bonding".

Electrode pads of the semiconductor chip are then connected to the distal ends of the tongue segments of the metal frame by gold wires. This step is generally called "wire bonding".

The lead frame structure on which the semiconductor chip is mounted is inserted into a cavity, in which the lead frame structure is molded (resin-sealed). As a result, the semiconductor chip, the die pad, the wire and the distal ends of the tongue segments are coated with a molding resin. This step is generally called "molding". The resulting structure, made of the molding resin, is called a package.

The tongue segments are then cut off from the frame, and thereafter those portions of the leads which project from the package are shaped into predetermined shapes, thereby forming the "outer leads" of a semiconductor package device.

Finally, the portion of the die pad support, which projects from the package, is cut off, thereby cutting off the package from the metal frame.

Through the above steps, a semiconductor package device is completed.

In recent years, as semiconductor package devices have become thinner and thinner, and semiconductor chips to be mounted on the semiconductor package devices have become bigger and bigger, the following problems arise.

First, the die pad must be greater in accordance with the increase of the size of a semiconductor chip. In this case, if the number of die pad supports is small and cannot sufficiently support the die pad, the die pad may bend, i.e., become less flat, during the die bonding or wire bonding steps. As a result, wires used in the wire bonding step cannot be bonded to the die pad, so that the manufacturing yield may become reduced.

This problem can be overcome by increasing the number of die pad supports for supporting the die pad, in order to increase the force for supporting the die pad.

Secondly, a semiconductor package device of a surface mounting type is mounted on a print circuit board, in general, together with the other electronic chip elements, by means of reflow soldering. In this case, during heating of the semiconductor package device in a reflow furnace (e.g., infrared heating, VPS (Vapor Phase Soldering), etc.), water contained in the package (molding resin) may be abruptly vaporized and expand particularly in a gap formed in a lower portion of the die pad, resulting in a crack in the lower surface of the package. If the package device is thin, the crack may cause the device to be broken.

This problem can be overcome by increasing the number of die pad supports extending from the die pad toward the outside of the package, in order to discharge vapor generated in the lower portion of the die pad from the package, so that a discharge path of the vapor can be assured.

Thirdly, in spite of the above first and second problems, when a small semiconductor chip is packaged, the size of a die pad must be decreased, since the wires cannot be exceedingly short. Hence, in this case, the number of supports need not be increased.

To overcome all of the first to third problems, it is only necessary to design a lead frame structure having die pad supports of the number required for the particular situation. However, even if semiconductor packages of the same size (configuration) are to be formed, various lead frame structures having a different number of die pad supports at different positions may be required, since the die pad supports can be formed only limited positions in consideration of the chip size, the position of the bonding pad and the arrangement of tongue segments (leads).

When semiconductor chips are packaged, if lead frame structures, having various number of die pad supports at various positions, are used, a great number of cutting dies, corresponding to the positions and the number of die pad supports of the lead frame structures, must be prepared in order to cut the die pad supports after the semiconductor chips are resin-sealed. This will result in a high manufacturing cost.

In addition, since a cutting die must be replaced with another cutting die, in accordance with different types of lead frame structures, the manufacturing efficiency will be lowered.

It is accordingly an object of the present invention to provide a lead frame structure which enables the production of semiconductor package devices with one type of cut die, even when the position and number of die pad supports for supporting the die pad are altered.

This invention can be more fully understood from the following detailed description when taken in conjunction with the accompanying drawings, in which:
FIG. 1A is a plan view showing a lead frame according to an embodiment of the present invention;
FIG. 1 B is a longitudinal cross-sectional view, taken along the line 1 B-1 B in FIG. 1A, showing the lead frame according to the embodiment of the present invention;
FIG. 2A is a plan view showing a step of producing a semiconductor package device according to the embodiment of the present invention;
FIG. 2B is a cross-sectional view showing the step of producing a semiconductor package device according to the embodiment of the present invention;
FIG. 3A is a plan view showing a step of producing a semiconductor package device according to the embodiment of the present invention;
FIG. 3B is a cross-sectional view showing the step of producing a semiconductor package device according to the embodiment of the present invention;
FIG. 4A is a plan view showing a step of producing a semiconductor package device according to the embodiment of the present invention;
FIG. 4B is a cross-sectional view showing a step of producing a semiconductor package device according to the embodiment of the present invention;
FIG. 5A is a plan view showing a step of producing a semiconductor package device according to the embodiment of the present invention;
FIG. 5B is a cross-sectional view showing the step of producing a semiconductor package device according to the embodiment of the present invention;
FIG. 6A is a side view showing a semiconductor package device according to the embodiment of the present invention;
FIG. 6B is a longitudinal cross-sectional view, taken along the line 6B-6B in FIG. 6A, showing the semiconductor package device according to the embodiment of the present invention;
FIG. 7 is a plan view showing a reference lead frame according to the embodiment of the present invention;
FIG. 8A is a plan view showing a step of producing a semiconductor package device using the reference lead frame according to the embodiment of the present invention;
FIG. 8B is a cross-sectional view showing the step of producing a semiconductor package device using the reference lead frame according to the embodiment of the present invention;
FIG. 9A is a plan view showing a step of producing a semiconductor package device according to another embodiment of the present invention;
FIG. 9B is a cross-sectional view showing the step of producing a semiconductor package device according to another embodiment of the present invention;
FIG. 10A is a plan view showing a step of producing a semiconductor package device according to another embodiment of the present invention; and
FIG. 10B is a cross-sectional view showing the step of producing a semiconductor package device according to another embodiment of the present invention.

In general, when a lead frame structure is designed, the sizes of a die pad and a package and the pitch of tongue segments (leads) are first determined. Thereafter, the arrangement of the tongue segments (leads) is determined. The position and the number of die pad supports for supporting the die pad are determined so that the die pad supports may not interfere with the tongue segments.

In the step of wire bonding, since the connection length of a wire is limited, one die pad of the greatest size does not necessarily cover all the various sizes of semiconductor chips.

Therefore, when semiconductor package devices of the same package size are to be produced, several kinds of lead frame structures having different sizes of die pads must be designed. Accordingly, the position and the number of die pad supports are varied in accordance with the designs of lead frame structures.

A lead frame structure of the present invention will be described on the assumption of the above matters.

When the lead frame structure of the present invention is designed, the shape of a reference lead frame structure is first determined. A lead frame structure having the greatest number of die pad supports is selected as the reference lead frame structure, when semiconductor package devices of the same package size are produced.

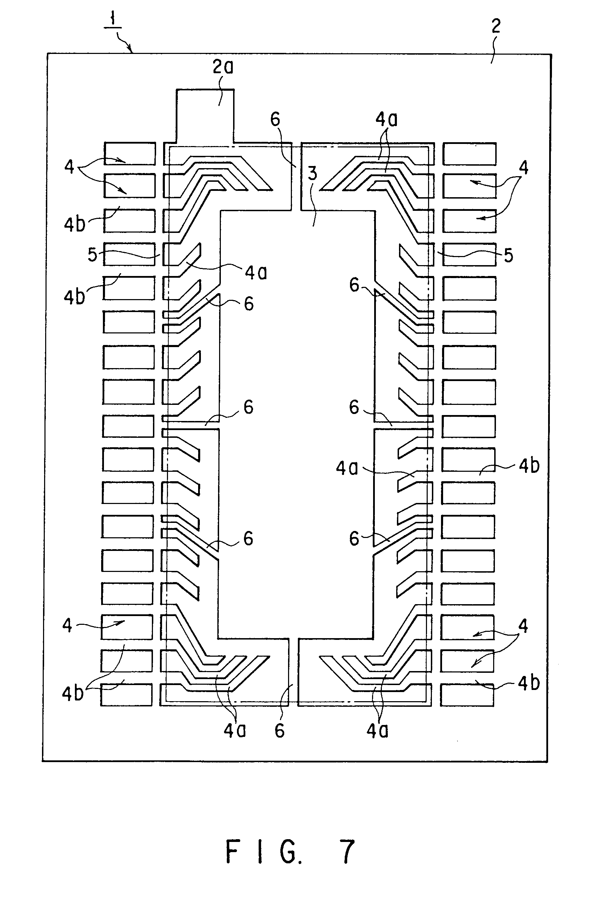

A structure of the reference lead frame structure will be described with reference to FIG. 7.

A lead frame structure 1 is integrally formed of a metal plate material, such as a copper plate, by press or etching. A die pad 3, on which a semiconductor chip is to be die-bonded, is formed within a frame 2. A plurality of tongue segments 4 extend from the frame 2 toward the die pad 3.

The middle portions of the tongue segments 4 are supported by dam bars 5 formed within the frame 2. The die pad 3 is supported by six die pad supports 6 extending from the dam bars 5 and two die pad supports 6 extending directly from the frame 2. In summary, the die pad 3 is supported by the eight die pad supports 6.

The portions of tongue segments 4 which is located on the inside of the dam bars 5 are called inner leads 4a and the portions thereof which is located on the outside of the dam bars 5 are called outer leads 4b.

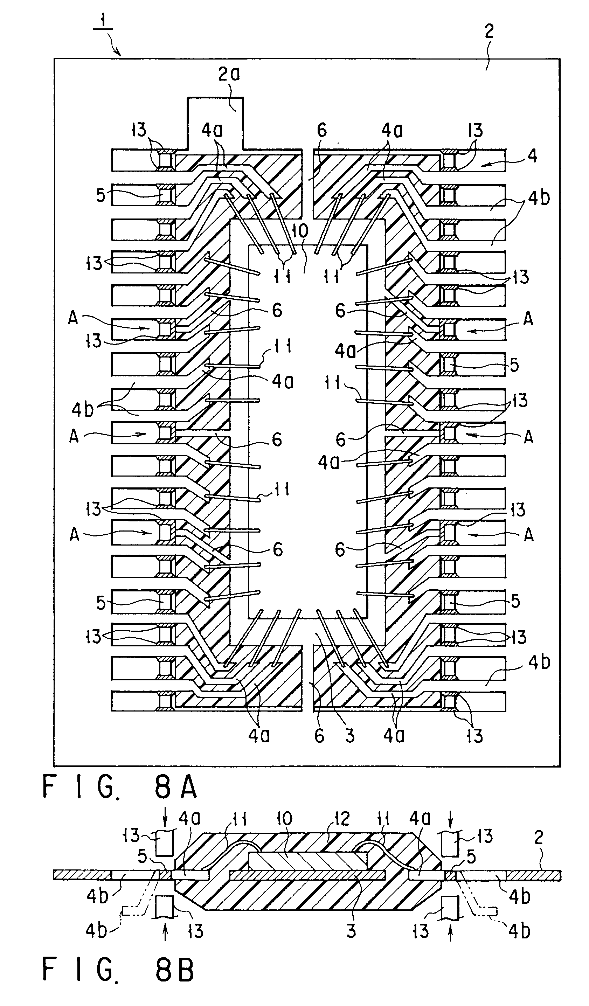

A step of mounting a semiconductor chip onto the reference lead frame structure 1 to produce a semiconductor package device will be described with reference to FIGS. 8A and 8B.

First, a semiconductor chip 10 is fixed to the die pad 3 (die bonding). Then, electrode pads (not shown) provided in the semiconductor chip 10 are connected to the inner leads 4a by gold wires 11 shown in FIG. 8 (wire bonding).

Thereafter, the frame structure is subjected to molding. The molding is performed in the following manner: the portion of the frame structure indicated by a dot-and-dash line shown in FIG. 7 is placed in a cavity of a mold, and a melted molding resin is then injected into the cavity.

The molding resin can be injected through a cut portion 2a shown in FIG. 7. As a result of the molding, the die pad 3, the semiconductor chip 10, the inner leads 4a and the wires 11 are encapsulated by a package (cured mold resin) 12 shown in FIGS. 8A and 8B.

The molding resin which overflows the cavity, i.e., the molding resin which flows out of the dot-and-dash line shown in FIG. 7, is dammed by the dam bars 5 so as not to flow to the outer leads 4b.

When the package 12 has been formed by the molding, the lead frame structure 1 is taken out of the cavity. Then, the dam bars 5 and the die pad supports 6 extending from the dam bars 5 are cut by a cutting die 13 having blades of a pattern as shown in FIGS. 8A and 8B.

The cutting die 13 is characterized in that six blades corresponding to the positions (A) of the die pad supports 6 have a shape different from that of the other blades, in order to cut the die pad supports 6.

When the dam bars 5 and the first die pad supports 6 have been cut, the outer leads 4b are cut off from the frame 2 and bent into a predetermined shape as indicated by a two-dot-and-dash line shown in FIG. 8B.

Then, the two die pad supports 6 remaining in both end portions of the die pad 3 in the longitudinal direction pad are cut off from the frame 2. Thus, a semiconductor package device is completed.

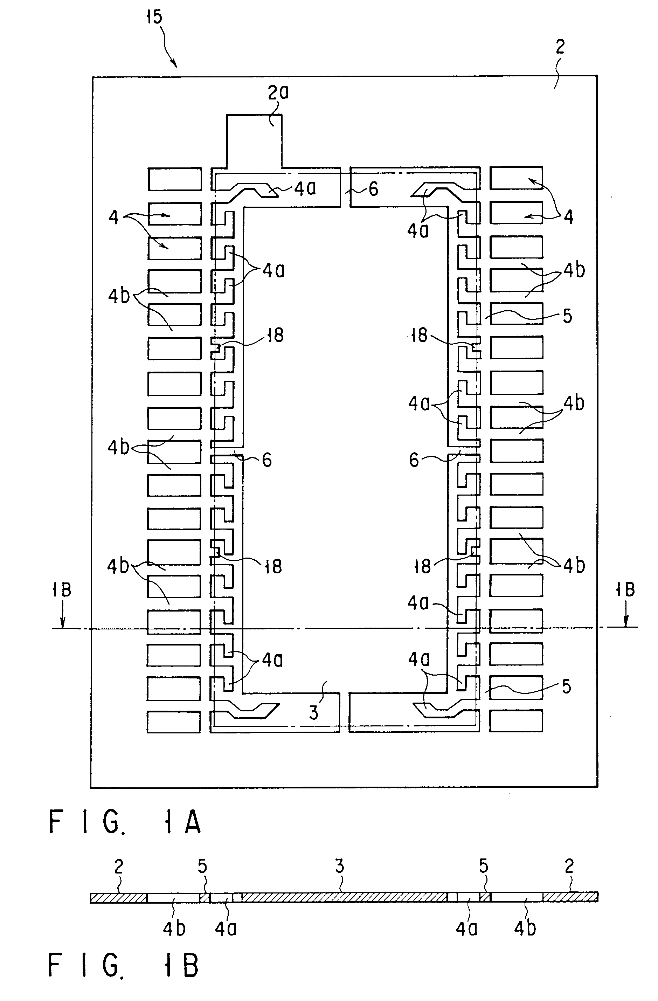

A structure of a lead frame structure of the present invention designed on the basis of the reference lead frame structure 1 will now be described with reference to FIG. 1A. The same elements as those of the reference lead frame structure 1 are identified with the same reference numerals as used for the reference lead frame structure 1, and descriptions thereof are omitted.

The lead frame structure 15 is designed on the basis of the reference lead frame structure 1, as described above, and used to produce a semiconductor package device, which incorporates a semiconductor chip 10 of a size different from that of the chip to be mounted on the reference lead frame structure 1 and has a package 12 of the same size and outer leads 4b of the same number as in the semiconductor package device produced using the reference lead frame structure 1.

In other words, the lead frame structure 15 is designed such that a mold region indicated by the dot-and-dash line shown in FIG. 1 (the size of the package 12) and the number and pitch of the outer leads 4b are the same as those in the reference lead frame structure 1, but the size of the die pad 3 can be different in accordance with the size of the semiconductor chip 10 which is to be mounted thereon.

For example, the lead frame structure 15 shown in FIG. 1A according to an embodiment of the present invention is designed such that a semiconductor chip 10 greater than the semiconductor chip 10 to be mounted on the reference lead frame structure 1 can be mounted. For this reason, the surface area of the die pad 3 is greater than that of the die pad 3 of the reference lead frame structure 1.

When the lead frame structure 15 is designed, it is required that the inner leads 4a be as long as a predetermined value, in order to keep the wires 11 and the semiconductor chip 10 connected to the distal ends of the inner leads 4a away from a contaminant which may enter the package 12 through the tongue segments 4 and corrode the wires 11 and the semiconductor chip 10.

In the lead frame structure 15, the distance between the die pad 3 and the dam bar 5 is smaller than that in the reference lead frame structure 1, as the die pad 3 is greater. Therefore, the inner leads 4a are substantially 90 bent, in order to maintain the predetermined length of the inner leads 4a.

The positions of the die pad supports 6 are determined on the basis of the size of the die pad 3 and the shape of the inner leads 4a (tongue segment). Thus, since the inner leads 4a are bent in this lead frame structure 15, the distance between the inner leads 4a are shorter as compared to that in the reference lead frame structure 1, resulting in that the die pad supports 6 can be provided at merely limited portions.

According to this embodiment, the lead frame structure 15 has only two of the six die pad supports 6 extended from the dam bars 5 of the reference lead frame structure 1, i.e., two die pad supports 6 at the center of the die pad 3 in the longitudinal direction, and the other four first die pad supports 6 are replaced with the dummy die pad supports 18 as shown in FIG. 1.

As apparent from FIG. 1, although the dummy die pad supports 18 extend from the dam bars 5 as the first die pad supports 6, they do not reach the die pad 3. In other words, the dummy die pad supports 18 designed are not actually used to support the die pad 3.

Moreover, the dummy die pad supports 18 are designed so as to reach the mold region indicated by the dot-and-dash line in FIG. 1A but not interfere with the inner leads 4a.

Since the dummy die pad supports 18 are provided at the positions corresponding to those of the die pad supports 6 of the reference lead frame structure 1, the lead frame structure 15 of this embodiment has the same number (six) of die pad supports extended from the same positions of the dam bars 5 as in the reference lead frame structure 1.

A step of mounting a semiconductor chip onto the lead frame structure 15 to produce a semiconductor package device will now be described.

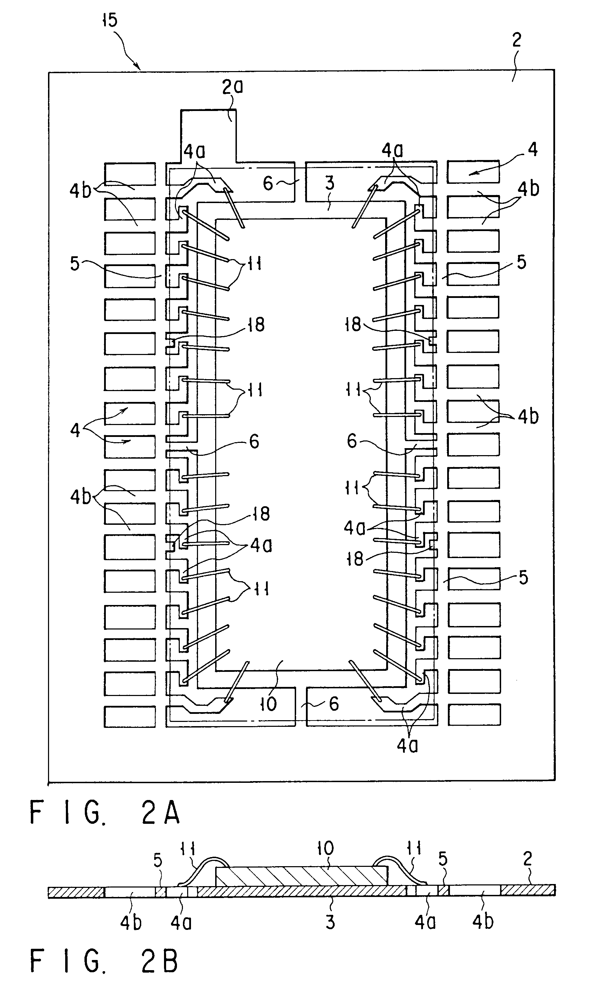

First, as shown in FIGS. 2A and 2B, a semiconductor chip 10 is fixed to the die pad 3 (die bonding), and electrode pads (not shown) of the semiconductor chip 10 are connected to the inner leads 4a by wires 11 (wire bonding).

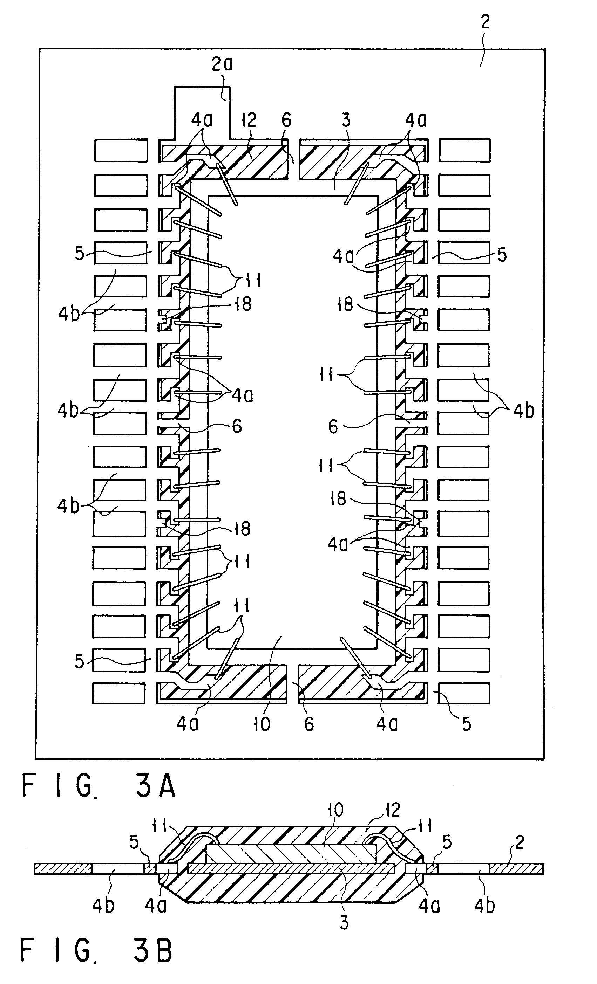

The frame structure 15 is then subjected to molding to form a package 12 as shown in FIGS. 3A and 3B. The molding is performed with the same mold as used in the case of the reference lead frame structure 1. Thus, the die pad 3, the inner leads 4a, the semiconductor chip 10 and the wires 11 are encapsulated by a package 12 indicated by the dot-and-dash lines shown in FIGS. 1 A and 2A.

As shown in FIG. 3A, not only the die pad supports 6 but also the distal end portions of the dummy die pad supports 18 are covered by the package 12.

The dam bars 5 the die pad supports 6 and the dummy die pad supports 18 are cut off by the same cutting die 13 as used to cut the dam bars 5 and the die pad supports 6 of the reference lead frame structure 1.

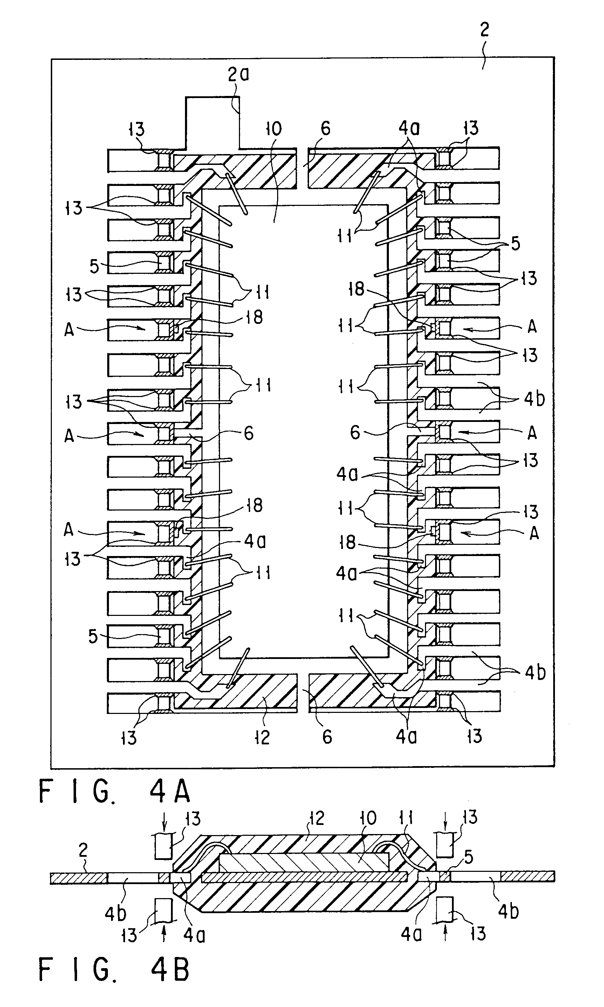

The cutting die 13 has six blades corresponding to the positions A of the die pad supports, as shown in FIGS. 4A and 4B. The dam bars 5 and the die pad supports 6 and 18 extending from the dam bars 5 are cut off by the cutting die 13.

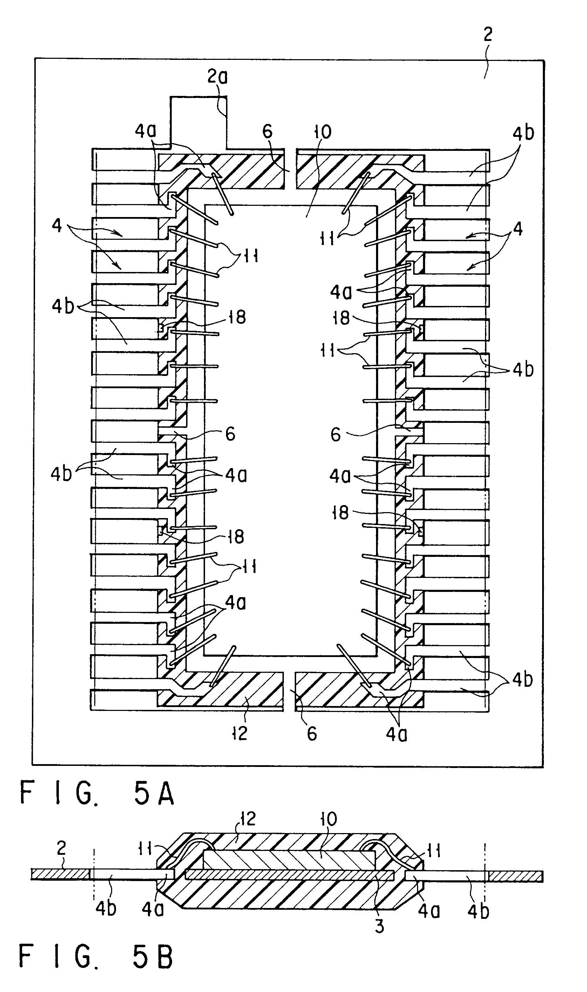

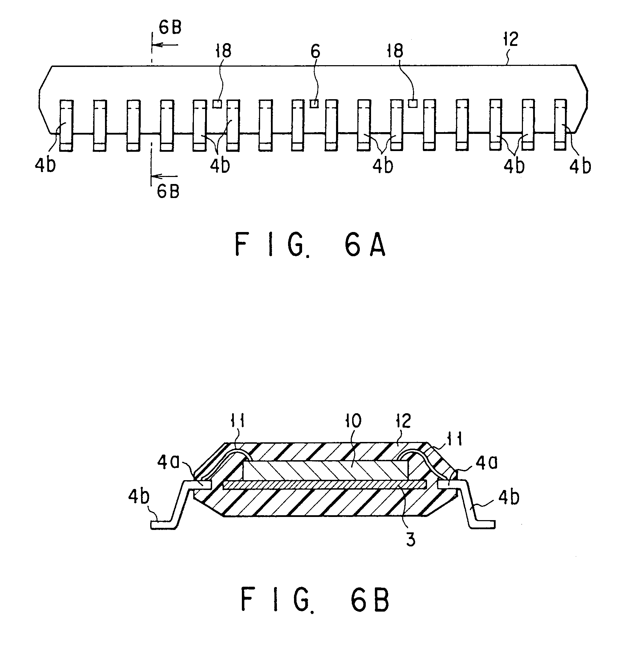

When the dam bars 5 and the die pad supports 6 and 18 have been cut, the outer leads 4b are cut off along the two-dot-and-dash line in FIGS. 5A and 5B from the frame 2 and bent into a predetermined shape as shown in FIGS. 6A and 6B.

Finally, the two die pad supports 6 remaining in both end portions of the die pad 3 in the longitudinal direction are cut off from the frame 2. Thus, a semiconductor package 12 is cut off from the frame 2.

A semiconductor package device is completed through the above steps. The package size of this semiconductor package device (the size of the package 12) and the number and pitch of the outer leads 4b are the same as those in the semiconductor package device produced by means of the reference lead frame structure 1.

The distal ends of the dummy die pad supports 18 remain in the package 12 and the cross sections of the dummy die pad supports 18 are exposed through side surfaces of the package 12 as shown in FIG. 6A.

In the above embodiment, the four die pad supports 6 of the reference lead frame structure 1 are replaced with the dummy die pad supports 18. However, the number of the dummy die pad supports 18, which replace the die pad supports 6, can be altered in accordance with the size of the die pad 3 or the arrangement of the inner leads 4a (tongue segments).

For example, in some arrangement of the inner leads 4A, no die pad support 6 can be extended from the dam bars 5, due to lack of space. In this case, all the die pad supports 6 extended from the dam bars 5 of the reference frame 1 are replaced with the dummy die pad supports 18.

Even in this structure, since the die pad supports (including the dummy die pad supports 18) of the same number are provided at the same positions as in the reference lead frame structure 1, the lead frame structure can be processed with the same cutting die 13 as used to cut the dam bars 5 and the die pad supports 6 of the reference lead frame structure 1, in the same manner as in the above embodiment.

The lead frame structure 15 of the present invention is formed on the basis of the reference frame 1 having the greatest number of die pad supports (true die pad supports), i.e., part of the die pad supports 6 of the reference lead frame structure 1 are replaced with the dummy die pad supports 18.

This structure has the following advantages:

Since the same number of die pad supports, including dummy die pad supports 18, are formed at the same positions as in the reference lead frame structure 1, the lead frame structure 15 having the less number of the die pad supports 6 can be processed with the same cutting die 13 as used to process the reference lead frame structure 1.

Accordingly, it is unnecessary to prepare a number of cutting dies, resulting in that semiconductor packages can be produced more easily at a lower cost and that the cutting die is prevented from breakage.

More specifically, according to the conventional art, there is no idea of forming dummy die pad supports in the lead frame structure, and different cutting dies are used to cut lead frame structures of different patterns. For this reason, a number of cutting dies must be prepared and one cutting die must be replaced with another in accordance with the pattern of the lead frame structure. This is disadvantageous from the viewpoint of cost and efficiency.

It is possible that lead frame structures having different patterns are processed with the same cutting die 13 as used to cut the reference lead frame structure 1. However, in this case, the blades of the cutting die 13, as indicated by A in the drawings, cut the cured molding resin (the material of the package 12) which has overflown near the dam bars 5, instead of the die pad supports 6. Since the molding resin contains 40 wt% of Filler (Si0₂ or A1₂0₃), which is harder than the material of the frame 2 (copper), the blades are liable to break or wear, thereby shortening the lifetime of the cutting die 13.

As described above, the present invention has the advantages that semiconductor package devices can be produced easily at a relatively low cost and the cutting die can be prevented from breakage.

The present invention is not limited to the above embodiment, but can be variously modified within the scope of the invention.

First, for example, although the reference lead frame structure 1 has eight die pad supports 6 in the above embodiment, the number of die pad supports 6 of the reference lead frame structure 1 may be more than or less than eight.

Secondly, in the above embodiment, the dummy die pad supports 18 are made of the same material as that of the lead frame structure 15 (frame 2). However, they can be made of any other material which is softer than the molding resin.

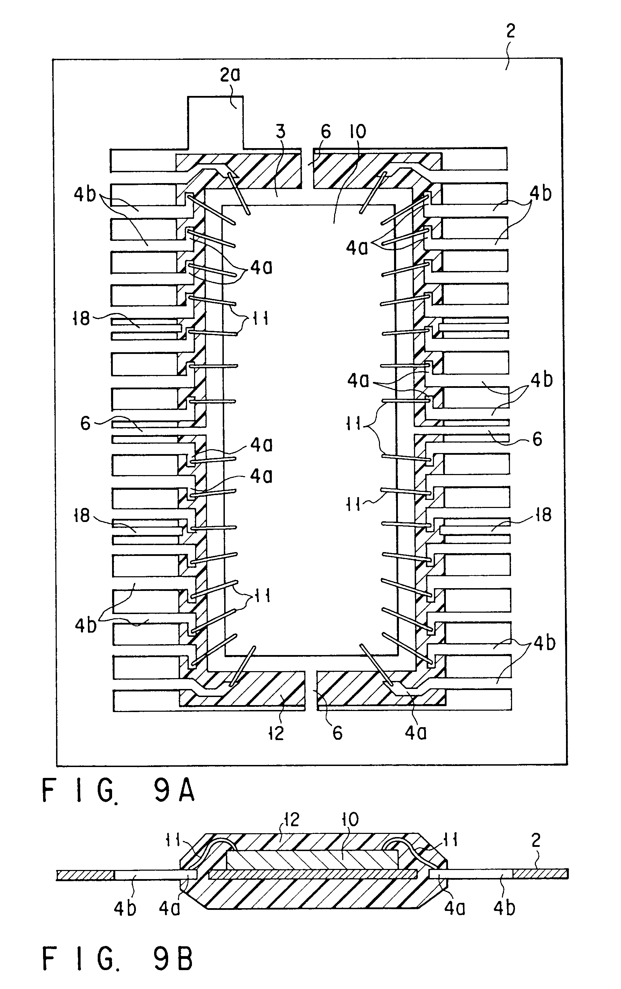

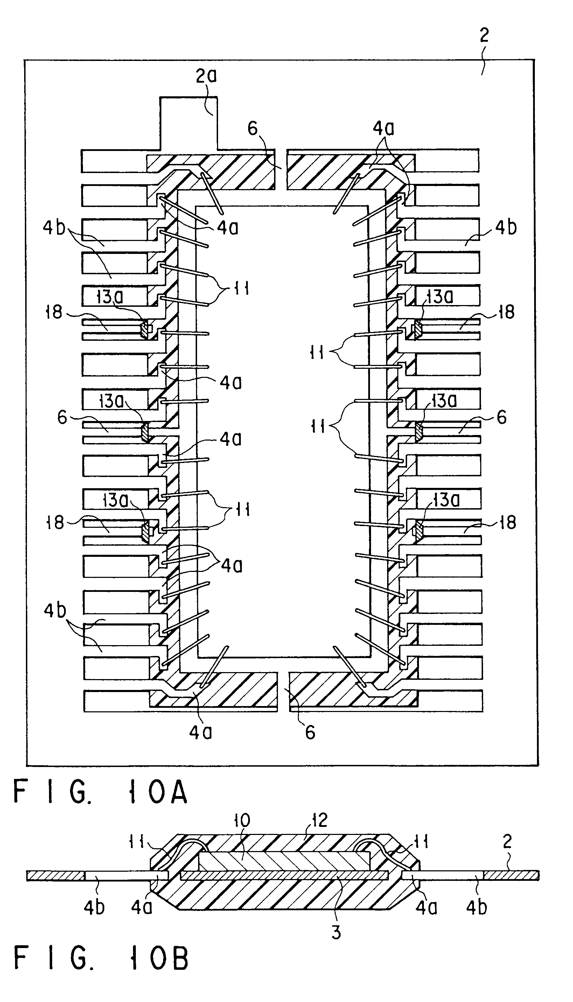

Thirdly, the lead frame structure 15 of the above embodiment has the dam bars 5. However, the dam bars 5 need not be provided, in which case, the die pad supports 6 and the dummy die pad supports 18 are directly extended from the frame 2. A cutting die 13a used in this case has merely six blades for cutting the true and dummy die pad supports 6 and 18, as shown in FIGS. 9A, 9B, 10A and 10B.

Fourthly, in the above embodiment, the number of true die pad supports 6 is altered in accordance with the surface area of the die pad 3. However, even if the surface area of the die pad 3 is not changed, the die pad supports 6 can be replaced with the dummy die pad supports 18 in order to reduce the number of the die pad supports 6.

Fifthly, in the above embodiment, part of the six die pad supports 6 extended from the dam bars 5 are replaced with the dummy die pad supports 18. However, the two die pad supports 6 provided at both end portions of the die pad 3 in the longitudinal direction can be replaced with the dummy die pad supports 18.

Sixthly, in the above embodiment, the dummy die pad supports 18 have such a length as to reach the region which is sealed with the molding resin (package 12). However, the dummy die pad supports 18 need not reach this region. It is only necessary that the dummy die pad supports 18 have a length which can be cut together with the true die pad supports 6 by the cutting die 13. However, if the dummy die pad supports 18 reach the package 12, the cutting die 13 is prevented from breakage more effectively, since the cutting die 13 will not fail to cut the die pad supports.

Although the dummy die pad supports 18 remain in the package 12 in the above embodiment (FIG. 6), they can be removed from the package 12 when cut by the cutting die 13.

## Claims

1. A lead frame structure structure (15) used to produce a semiconductor package device having a semiconductor chip (10), a package (12) made of a molding resin for covering the semiconductor chip (10), and leads, each having a distal end and the other end, the distal end being connected with the semiconductor chip (10) in the package (12), and the other end projecting outside the package, said lead frame structure structure (15) comprising:
a die pad (3) having a surface on which the semiconductor chip (10) can be mounted, said die pad being to be buried in the package (12) in a subsequent process;
a frame (2) to be removed in a subsequent process;
tongue segments (4) extending from the frame (2), each having a distal end (4a) opposed to the die pad (3) with a gap therebetween and a proximal end (4b) connected to the frame, said tongue segments (4) being to become leads in a subsequent process; and
a die pad support (6) for connecting the die pad (3) with the frame (2), said die pad support (6) being to be cut in a subsequent process;
characterized by further comprising
a dummy die pad support (18) extending from the frame (2) and having such a length as not to reach the die pad (3), said dummy die pad support (18) being to be cut in the process of cutting the die pad support (6).

2. The lead frame structure according to claim 1, characterized in that the frame (2) comprises a dam bar (5), connected in middle portions of the tongue segments (4), for preventing the molding resin flowing toward the proximal end (4b) of each of the tongue segments (4) when the package (12) is formed and for supporting the die pad support (6) or the dummy die pad support (18), said dam bar (5) being to be removed in a subsequent process.

3. The lead frame structure according to claim 1, characterized in that the dummy die pad support (18) has a distal end (18a) which is to be covered by the package (12) in a subsequent process.

4. The lead frame structure according to claim 1, characterized in that the dummy die pad support (18) is formed so as not to interfere with distal ends (4a) of the tongue segments (4).

5. The lead frame structure according to claim 1, characterized in that the dummy die pad support (18) is made of material softer than that of the package (12).

6. A method for producing a semiconductor package device characterized by comprising:
a first step of preparing a lead frame structure structure (15) comprising a die pad (3) having a surface on which a semiconductor chip (10) is to be mounted; a frame (2); tongue segments (4) extending from the frame (2), each having a distal end (4a) opposed to the die pad (3) with a gap therebetween and a proximal end (4b) connected to the frame (2); a die pad support (6) for connecting the die pad (3) with the frame (3); and a dummy die pad support (18) extending from the frame (2) and having such a length as not to reach the die pad (3);
a second step of mounting a semiconductor chip (10) to the die pad (3);
a third step of connecting distal end portions (4a) of the tongue segments (4) with the semiconductor chip (10) mounted on the die pad (3);
a fourth step of sealing the semiconductor chip (10), the die pad (3) and the distal ends (4a) of the tongue segments (4) with a resin, thereby forming a package (12);
a fifth step of cutting the die pad support (6) and the dummy die pad support (18) by a die (13); and
a sixth step of cutting the frame (2) from other ends (4b) of the tongue segments (4) to remove the frame (2) off.

7. A semiconductor package device produced by the method as recited in claim 6.
